# EUROPEAN PATENT APPLICATION

(11) **EP 2 256 147 A1**
(43) Date of publication of application: **01.12.2010**
(21) Application number: 09717164.9
(22) Date of filing: 02.03.2009
(51) Int. Cl.: C08G 77/04, C08L 83/04, C09K 3/10, H01L 23/29, H01L 23/31

(54) **THERMOSETTING ORGANIC-INORGANIC HYBRID TRANSPARENT MATERIAL**

(30) Priority: 07.03.2008 JP 2008057419
(71) Applicant: Central Glass Company, Limited, Yamaguchi 755-0001 (JP)
(72) Inventor: The designation of the inventor has not yet been filed
(74) Representative: Manitz, Finsterwald & Partner GbR
(86) International application number: PCT/JP2009/053817
(87) International publication number: WO 2009/110405

(57) **Abstract**

There is disclosed a thermosetting organic-inorganic hybrid transparent material which is **characterized by** including a main material that has a siloxane skeleton modified with an organic substituent, and a curing agent. The main material and the curing agent are mixed, and the mixture is coated on an adherend and cured by heating. With these steps, a transparent bonding/sealing is achieved.

## Description

### Technical Field:

The present invention relates to both a thermosetting organic-inorganic hybrid transparent material that exhibits an excellent adherence to various boards and objects to be adhered, and a method of producing the hybrid transparent material.

### Background Art:

In transparent sealing materials for sealing solar battery elements of a solar battery module, light-receiving portions of an optical communication and light emitting diodes (LED) and in adhesives for bonding a semiconductor package and radiating fins, there is a need of excellent adherence to various boards and objects to be adhered. Furthermore, in such materials and adhesives, there is a need of excellent durability against a temperature change appearing in a subsequent process and in use.

The temperature change appearing in the subsequent process is for example the temperature change caused by a heating process for achieving a soldering connection. In recent years, from the point of view of environmental issues, the solder for connection has changed from the conventional Sn-Pb eutectic solder (melting point = 183°C) to the lead-free solder (melting point = 220°C). With such solder change, the solder reflowing temperature has increased from the conventional 230°C (in case of Sn-Pb eutectic solder) to 260°C (in case of lead-free solder), which has demanded the adhesives and sealing materials much effective anti-reflowing property. As a method for evaluating the temperature change of such adhesives and sealing materials in use, there is a cooling/heating cycling test provided on the assumption that the adhesives and sealing materials are practically used.

As the transparent sealing materials, there have been used materials that are a material including a bisphenol A-type epoxide resin as a main material and an acid anhydride as a curing agent, an ethylene-vinyl acetate copolymer with higher vinyl-acetate and a polyvinyl butyral. In order to meet the above-mentioned severe demand in characteristics, various improvements in composition, addition of UV absorbents, addition of organic peroxides and the like have been tried (for example, the tries disclosed in Patent Documents 1 to 3). In addition, an epoxy resin copolymerized with a high heat-resistant silicone has been developed.
Patent Document 1 ... Japanese Laid-open Patent Application (Tokkai) 2006-066761
Patent Document 2 ... Japanese Laid-open Patent Application (Tokkai) 2003-228076
Patent Document 3 ... Japanese Laid-open Patent Application (Tokkaihei) 10-253972

### Summary of Invention:

In transparent sealing materials for sealing solar battery elements of a solar battery module, light-receiving portions of an optical communication and light emitting diodes (LED) and in adhesives for bonding a semiconductor passage and radiating fins, there are many types that are high in water absorbency. Thus, if elements that are previously moisturized are heated to a temperature needed for soldering, water in the elements is vaporized while rapidly expanding, and thus, pressure caused by such expanding tends to induce undesired delamination (or scaling) of boundary of the bonding surface. In fact, hitherto, there are no transparent adhesive and sealing material that are low in water absorbency and exhibit no delamination (or scaling) and cracks when subjected to a solder reflowing test and a cooling/heating cycling test.

According to the present invention, there are provided a thermosetting organic-inorganic hybrid transparent material, a method for producing the material and a method for using the material as a sealing material, the material being characterized by including a main material that has a siloxane skeleton modified with an organic substituent, and a curing agent.

### Detailed Description:

The thermosetting organic-inorganic hybrid transparent material according to the present invention is usable as a transparent sealing material that is used for sealing semiconductor light emitting elements, such as a light emitting diode (LED) and the like, used in various indicators, such as, back lights, indicating boards, displays and the like, for sealing solar battery elements of a solar battery module and for sealing light-receiving portions of an optical communication and is usable as an adhesive for boding a semiconductor passage and radiating fins. Furthermore, the material according to the present invention is usable as a sealing/coating material for a display element such as PDP (plasma display panel) and the like, and applicable to an industrial field wherein a low-melting glass is used, such as a field of using a material for an optical information communication device, such as a flashing switch, optocoupler and the like, a material for optical instruments, a material for optically functional (nonlinear) optical material, a material for an adhesive and the like wherein a low-melting glass is used, and applicable to an industrial field wherein organic materials such as epoxy resin and the like are used.

By mixing the main material and the curing agent according to the invention, coating the mixed material and heating and curing the coated material, there can be established bonding and sealing of the transparent material without producing delamination and cracks against a temperature change (or environment change) that would appear in a subsequent process and in use. That is, the thermosetting organic-inorganic hybrid transparent material according to the present invention is of a two-liquid type, and when it is intended to use it, the main material and the curing agent are mixed, the mixed material is coated and then the coated material is heated and cured to produce a transparent sealing.

More specifically, into a main material including a thermoplastic siloxane oligomer having a siloxane skeleton modified with a hydrocarbon group, such as a saturated hydrocarbon group, an aromatic hydrocarbon group or a hydrocarbon group with aromaticity, there is added an organometallic compound as a curing agent and then the compound-added main material is coated on an adherend that has been subjected to a primer treatment, and the material-coated adherend is heated at a temperature lower than or equal to 200°C to cure the coated material. With this process, there is produced a transparent sealing material that is suppressed from having undesired delamination of coated cured material from the adherend and undesired cracks of the coated cured material.

According to the present invention, there are provided an organic-inorganic hybrid transparent sealing material and a method of producing the sealing material, the sealing material being produced by mixing a main material having a siloxane skeleton modified by an organic substituent with a curing agent, coating the mixed material onto an adherend and heating and curing the coated material on the adherend.

It is preferable to use, as the curing agent, at least one of organometallic compounds of Sn-system, Ti-system, Al-system, Zn-system, Zr-system, Bi-system, Fe-system, Co-system, Mn-system, P-system and Ni-system. By the addition of such curing agent or agents, the organic-inorganic hybrid material can be cured at a low temperature in a shortened time as compared with a case in which such curing agent or agents are not used.

It is preferable that the amount of the curing agent or agents is smaller than or equal to °wt%. If the amount of the curing agent or agents exceeds 50wt%, rapid condensation reaction takes place which tends to leave a residual foam.

It is preferable that the curing is made by heating it at a temperature lower than or equal to 200°C. The temperature higher than 200°C may bring about a case in which the temperature is higher than the heat resistance of the adherend. If the heat resistance of the adherend is low, the curing is established at a temperature below the heat resistance temperature by using a curing agent that exhibits the rapid condensation reaction. If desired, the heating may be carried out under an atmospheric pressure, increased pressure, decreased pressure or in an inert atmosphere. Furthermore, usage of a microwave heating is effective.

It is preferable that the hardness shows no change by the heat of lower than 200°C and water vapor that would appear after the curing. This is for causing the organic-inorganic hybrid transparent sealing material to avoid undesired variation with time even when the material is practically used in various atmospheres (temperature, humidity).

It is preferable that a saturated water absorption rate of the material after its curing is lower than or equal to 0.3wt%. If the rate is higher than 0.3wt%, it shows a high water absorbent and thus, in a solder reflowing test and cooling/heating cycling test that would be carried out thereafter, undesired delamination and cracks tend to appear. It is more preferable that the saturated water absorption rate is lower than or equal to 0.2wt%.

It is preferable that the cured material has a good adherence. If the adherence is poor, undesired delamination tends to occur inducing defective matters, such as poor appearance, poor contact, poor strength, breaking of wire and the like.

Furthermore, it is preferable that the material contains a saturated hydrocarbon group as the organic substituent. In the saturated hydrocarbon group, there are for example, methyl group, ethyl group, (n-, i-) propyl group and (n-,i-,s-,t-) butyl group. Particularly, the methyl group is preferable.

Furthermore, it is preferable that the material contains, as the organic substituent, an aromatic hydrocarbon group or a hydrocarbon group with aromaticity. In the aromatic hydrocarbon group or the hydrocarbon group with aromaticity, there are, for example, phenyl group, naphthyl group, benzyl group, phenethyl group and naphthylmethyl group. Particularly, the phenyl group is preferable.

Furthermore, it is preferable that the main material contains therein a thermoplastic siloxane oligomer of which average molecular weight is smaller than or equal to 2000. Since the thermoplastic siloxane oligomer forms part of the network or the same remains in the network as an inert substance, undesired delamination and cracks that would be caused by a temperature change can be suppressed.

Furthermore, it is preferable that the cured material has an average transmittance higher than or equal to 80% with respect to a light with wavelengths of 350 to 800nm. If the average transmittance is lower than 80%, the electrical generating efficiency and luminous efficiency are lowered, and loss in communications is increased.

Furthermore, it is preferable that the adherend is previously treated by a primer. Applying the primer to an outer surface of the adherend is effective in improving the adherence. In the primer, there are synthetic rubber system, acrylic system, urethane system, epoxy system, silicone resin system, silane system and amine system. However, the invention is not limited to such systems. In the adherend, there are a board of glass, metal, plastic or ceramic, a printed circuit board and a flexible board. However, the invention is not limited to such boards.

In the following, embodiments of the present invention will be described. However, the present invention is not limited to the following embodiments.

### EMBODIMENT-1

### (Production of a main material)

In advance, a mixture of phenyl-trimethoxy-silane (PhSi(OMe)₃) and diphenyl-dimethoxy-silane (Ph₂Si(OMe)₂) was subjected to hydrolysis-polycondensation to produce thermoplastic siloxane oligomer of which average molecular weight is 530. Then, at room temperature, 30wt% of the thermoplastic siloxane oligomer was added to a mixture of 12g of alkoxy-silane (PhSi(OMe)₃) and 11g of dimethyl-dimethoxy-silane (Me₂Si(OMe)₂), and the oligomer-added mixture was dissolved by 70g of ethanol and thereafter 130g of water and 9mg of glacial acetic acid were added to the ethanol for their mixing. The soup (viz., the mixture solution thus produced) was stirred for 3 hours under a temperature of 100°C in an open atmosphere. With this, a water-clear viscous liquid was obtained. The viscous liquid thus obtained was dissolved by diethyl-ether and by using pure water, acetic acid was extracted. Thereafter, by distillation, the diethyl-ether was removed. With these steps, colorless viscous liquid (which will be referred to a main material hereinafter) was obtained.

### (Production of sealing samples)

Commercially available circuit-printed plastic boards were prepared and outer surfaces of the plastic boards were treated by an amine system primer. 10wt% of dibutyl-stannum-diacetate as a curing agent was added to the main material, and the main material thus mixed with the curing agent was coated on the outer surface of each of the plastic boards. Then, the coated plastic boards were heated at 60°C for 3 hours, at 100°C for 3 hours and at 150°C for 5 hours to produce sealing samples. Shore hardness of the cured sealing samples was D65. The hardness of the cured sealing samples was kept unchanged (D65) even after the same were held at 150°C for 100 hours or held at 40°C and 90%RH for 10 days. Furthermore, even when the cured sealing samples were subjected to a cooling/heating cycling test of -40°C to 100°C (viz., the test based on JIS C 0025), the samples exhibited an excellent adherence to the plastic board without showing undesired delamination (or scaling) and cracks. Furthermore, even when, after being held at 40°C and 90%RH for 10 days, the samples were subjected to a solder heat resistant test of 260°C-10 seconds (viz., test based on JIS C 60068-2-20), the tested samples still exhibited an excellent adherence to the plastic boards without showing delamination and cracks.

### (Production of plate like samples)

By using the same material and production condition as the above, plate like samples each having a thickness of 1 mm were produced. The average transmittance of the plate like samples thus produced was 90% with respect to a light with wavelengths of 300 to 800nm. The saturated water absorbency of the samples was 0.11wt%.

### EMBODIMENT-2

### (Production of a main material)

In advance, a mixture of phenyl-trimethoxy-silane (PhSi(OMe)₃) and diphenyl-dimethoxy-silane (Ph₂Si(OMe)₂) was subjected to hydrolysis-polycondensation to produce thermoplastic siloxane oligomer of which average molecular weight is 600. Then, at room temperature, 25wt% of the thermoplastic siloxane oligomer was added to a mixture of 9g of alkoxy-silane (PhSi(OMe)₃) and 13g of dimethyl-dimethoxy-silane (Me₂Si(OMe)₂), and the oligomer-added mixture was dissolved by 70g of ethanol and thereafter 130g of water and 9mb of glacial acetic acid were added to the ethanol for their mixing. The soup (viz., the mixture solution thus produced) was stirred for 3 hours under a temperature of 60°C in a closed atmosphere and thereafter stirred for 2.5 hours under a backflow. After complete of reaction in the soup, diethyl-ether was added to the soup, and by using pure water, acetic acid was extracted. Thereafter, by distillation, the diethyl-ether was removed. With these steps, colorless viscous liquid (which will be referred to a main material hereinafter) was obtained.

### (Production of sealing samples)

Commercially available flexible boards were prepared and outer surfaces of the boards were treated by an amine system primer. 10wt% of bis-(lauroxydibutyltin)-oxide as a curing agent was added to the main material, and the main material thus mixed with the curing agent was coated on the outer surface each of the flexible board. Then, the coated flexible boards were heated at 60°C for 3 hours, at 100°C for 3 hours and at 150°C for 5 hours to produce sealing samples. Shore hardness of the cured sealing samples was D60. The hardness of the cured sealing samples was kept unchanged (D60) even after the same were held at 150°C for 100 hours or held at 40°C and 90%RH for 10 days. Furthermore, when the cured sealing samples were subjected to a cooling/heating cycling test of -40°C to 100°C (viz., the test based on JIS C 0025), the sample exhibited an excellent adherence to the flexible boards without showing undesired delamination (or scaling) and cracks. Furthermore, when, after being held at 40°C and 90%RH for 10 days, the samples were subjected to a solder heat resistant test of 260°C-10 seconds (viz., the test based on JIS C 60068-2-20), the samples still exhibited the excellent adherence to the flexible boards without showing delamination and cracks.

### (Production of plate like samples)

By using the same material and production condition as the above, plate like samples each having a thickness of 1mm were produced. The average transmittance of the plate like samples was 89% with respect to a light with wavelengths of 300 to 800nm. The saturated water absorbency of the plate like samples was 0.09wt%.

### EMBODIMENT-3

### (Production of a main material)

In advance, a mixture of phenyl-trimethoxy-silane (PhSi(OMe)₃) and double-ended silanol-polydiphenyl-siloxane (molecular weight = 1000, trade name = PDS-9931 produced by Gelest Inc.,) was subjected to hydrolysis-polycondensation to produce thermoplastic siloxane oligomer of which average molecular weight is 800. Then, at room temperature, 35wt% of the thermoplastic siloxane oligomer was added to a mixture of 10g of alkoxy-silane (PhSi(OMe)₃) and 12g of dimethyl-dimethoxy-silane (Me₂Si(OMe)₂), and the oligomer-added mixture was dissolved by 70g of ethanol and thereafter 135g of water and 9mg of glacial acetic acid were added to the ethanol for their mixing. The soup (viz., the mixture solution thus produced) was stirred for 3 hours under a temperature of 100°C in an open atmosphere. With this, a water-clear viscous liquid was obtained. The viscous liquid thus obtained was dissolved by diethyl-ether and by using pure water, acetic acid was extracted. Thereafter, by distillation, the diethyl-ether was removed. With these steps, colorless viscous liquid (which will be referred to a main material hereinafter) was obtained.

### (Production of sealing samples)

Commercially available flexible boards were prepared, and outer surfaces of the flexible boards were treated by a commercially available silane system primer. 12wt% of acetylaceton-aluminum as a curing agent was added to the main material, and the main material thus mixed with the curing agent was coated on the outer surface of each of the flexible boards. Then, the coated flexible boards were heated at 60°C for 3 hours, at 100°C for 3 hours and at 150°C for 5 hours to produce sealing samples. Shore hardness of the cured sealing sampled was D60. The hardness of the cured sealing samples was kept unchanged (D60) even after the same were held at 150°C for 100 hours or held at 40°C and 90%RH for 10 days. Furthermore, when the cured sealing samples were subjected to a cooling/heating cycling test of -40°C to 100°C (viz., the test based on JIS C 0025), the samples exhibited an excellent adherence to the plastic boards without showing undesired delamination (or scaling) and cracks. Furthermore, when, after being held at 40°C and 90%RH for 10 days, the samples were subjected to a solder heat resistant test of 260°C-10 seconds (viz., test based on JIS C 60068-2-20), the samples still exhibited an excellent adherence to the plastic boards without showing delamination and cracks.

### (Production of plate like samples)

By using the same material and production condition as the above, plate like samples each having a thickness of 1 mm were produced. The average transmittance of the plate like samples was 89%, and the saturated water absorbency of the plate like samples was 0.09wt%.

### EMBODIMENT-4

### (Production of a main material)

In advance, a mixture of phenyl-trimethoxy-silane (PhSi(OMe)₃) and double-ended silanoldiphenylsiloxane-dimethylsiloxane copolymer (molecular weight = 1000, trade name = PDS-1615 produced by Gelest Inc.,) was subjected to hydrolysis-polycondensation to produce thermoplastic siloxane oligomer of which average molecular weight is 720. Then, at room temperature, 40wt% of the thermoplastic siloxane oligomer was added to a mixture of 9g of alkoxy-silane (PhSi(OMe)₃) and 19g of methyl-phenyl-dimethoxy-silane (MePhSi(OMe)₂), and the oligomer-added mixture was dissolved by 70g of ethanol and thereafter 135g of water and 9mg of glacial acetic acid were added to the ethanol for their mixing. The soup (viz., the mixture solution thus produced) was stirred for 3 hours under a temperature of 100°C in an open atmosphere. With this, a water-clear viscous liquid was obtained. The viscous liquid thus obtained was dissolved by diethyl-ether and by suing pure water, acetic acid was extracted, and thereafter the diethyl-ether was removed. With these steps, colorless viscous liquid (which will be referred to a main material hereinafter) was obtained.

### (Production of sealing samples)

Float glass boards were prepared, and outer surfaces of the float glass boards were treated by a commercially available silane system primer. 10wt% of bis-(acetoxydibutyltin)-oxide as a curing agent was added to the main material, and the main material thus mixed with the curing agent was coated on each of the float glass boards. Then, the coated float glass boards were heated at 60°C for 3 hours, at 100°C for 3 hours and at 150°C for 5 hours to produce sealing samples. Shore hardness of the cured sealing samples was D60. The hardness of the cured sealing samples was kept unchanged (D60) even after the same were held at 150°C for 100 hours or held at 40°C and 90%RH for 10 days. Furthermore, when the cured sealing samples were subjected to a cooling/heating cycling test of -40°C to 100°C (viz., the test based on JIS C 0025), the samples exhibited an excellent adherence to the float glass boards without showing undesired delamination (or scaling) and cracks. Furthermore, when, after being held at 40°C and 90%RH for 10 days, the samples were subjected to a solder heat resistant test of 260°C-10 seconds (viz., the test based on JIS C 60068-2-20), the samples still exhibited the excellent adherence to the float glass boards without showing delamination and cracks.

### (Production of plate like samples)

By using the same material and production condition as the above, plate like samples each having a thickness of 1mm were produced. The average transmittance of the plate like samples was 89% with respect to a light with wavelengths of 300 to 800nm, and the saturated water absorbency of the plate like samples was 0.09wt%.

### EMBODIMENT-5

### (Production of a main material)

In advance, a mixture of phenyl-trimethoxy-silane (PhSi(OMe)₃), diphenyl-dimethoxy-silane (Ph₂Si(OMe)₂) and hexaphenyl-cyclotrisiloxane [(Ph₂SiO_{2/2})₃, molecular weight = 540] was subjected to hydrolysis-polycondensation to produce thermoplastic siloxane oligomer of which average molecular weight is 590. Then, at room temperature, 25wt% of the thermoplastic siloxane oligomer was added to a mixture of 6g of alkoxy-silane (PhSi(OMe)₃) and 14g of dimethyl-dimethoxy-silane (Me₂Si(OMe)₂), and the oligomer-added mixture was dissolved by 70g of ethanol and thereafter 130g of water and 9mg of glacial acetic acid were added to the ethanol for their mixing. The soup (viz., the mixture solution thus produced was stirred for 3 hours under a temperature of 100°C in an open atmosphere. With this, a water-clear viscous liquid was obtained. The viscous liquid thus obtained was dissolved by diethyl-ether and by using pure water, acetic acid was extracted. Thereafter, by distillation, the diethyl-ether was removed. With these steps, colorless viscous liquid (which will be referred to a main material hereinafter) was obtained.

### (Production of sealing samples)

Commercially available circuit-printed plastic boards were prepared and outer surfaces of the plastic boards were treated by a silane system primer. 10wt% of titanictetra (acetylacetonate) as a curing agent was added to the main material, the main material thus mixed with the curing agent was coated on the outer surface of each of the plastic boards. Then, the coated plastic boards were heated at 60°C for 3 hours, at 100°C for 3 hours and at 150°C for 5 hours to produce sealing samples. Shore hardness of the cured sealing samples was D55. The hardness of the cured sealing samples was kept unchanged (D55) even after the same were held at 150°C for 100 hours or held at 40°C and 90%RH for 10 days. Furthermore, even when the cured sealing samples were subjected to a cooling/heating cycling test of -40°C to 100°C (viz., the test based on JIS C 0025), the samples exhibited an excellent adherence to the plastic boards without showing undesired delamination (or scaling) or cracks. Furthermore, even when, after being held at 40°C and 90%RH for 10 days, the samples were subjected to a solder heat resistance test of 260°C-10 seconds (viz., test based on JIS C 60068-2-20), the tested samples still exhibited an excellent adherence to the plastic boards without showing delamination and cracks.

### (Production of plate like samples)

By using the same material and production condition as the above, plate like samples each having a thickness of 1mm were produced. The average transmittance of the plate like samples thus produced was 87% with respect to a light with wavelengths of 300 to 800nm. The saturated water absorbency of the plate like samples was 0.10wt%.

### (Comparative Example 1)

Commercially available flexible boards were prepared and outer surfaces of the boards were treated by an amine system primer. A commercially available silicone resin for sealing/bonding was coated on the outer surface of each of the boards to produce sealing samples (viz., comparative example). When subjected to the above-mentioned cooling/heating cycling test of -40°C to 100°C or after being held at 40°C and 90%RH for 10 days, subjected to the above-mentioned solder heat resistant test of 260°C-10 seconds, all of the sealing sample showed undesired delamination and cracks.

### (Comparative Example 2)

Commercially available circuit printed plastic boards were prepared and outer surfaces of the boards were treated by an epoxy system primer. A commercially available epoxy resin for sealing/bonding was coated on the outer surface of each of the boards to produce sealing samples (viz., comparative example). When subjected to the above-mentioned cooling/heating cycling test of -40°C to 100°C or after being held at 40°C and 90%RH for 10 days, subjected to the above-mentioned solder heat resistant test of 260°C-10 seconds, all of the sealing sample showed undesired delamination and cracks.

### (Comparative Example 3)

Commercially available circuit printed plastic boards were prepared and outer surfaces of the boards were treated by an amine system primer. A commercially available urethane resin for sealing/bonding was coated on the outer surface of each of the boards to produce sealing samples (viz., comparative example). When the sealing samples were held at 40°C and 90%RH for 10 days, the samples showed delamination. When the sealing samples were subjected to the solder heat resistant test of 260°C-10 seconds, all of the samples showed delamination and cracks.

## Claims

1. A thermosetting organic-inorganic hybrid transparent material which is **characterized by** including a main material that has a siloxane skeleton modified with an organic substituent, and a curing agent.

2. A thermosetting organic-inorganic hybrid transparent material as claimed in Claim 1, which is further **characterized in that** at least one of organometallic compounds of Sn-system, Ti-system, Al-system, Zn-system, Zr-system, Bi-system, Fe-system, Co-system, Mn-system, P-system or Ni-system is used as the curing agent.

3. A thermosetting organic-inorganic hybrid transparent material as claimed in Claim 1 or 2, which is further **characterized in that** the amount of the curing agent is smaller than or equal to 50wt%.

4. A thermosetting organic-inorganic hybrid transparent material as claimed in Claim 1, 2 or 3, which is further **characterized in that** the material is cured at a temperature lower than or equal to 200°C.

5. A thermosetting organic-inorganic hybrid transparent material as claimed in Claim 1, 2, 3 or 4, which is further **characterized in that** the cured material shows no change in hardness by a heat of lower than 200°C or water vapor.

6. A thermosetting organic-inorganic hybrid transparent material as claimed in Claim 1, 2, 3, 4 or 5, which is further **characterized in that** a saturated water absorption rate of the cured material is lower than or equal to 0.3wt%.

7. A thermosetting organic-inorganic hybrid transparent material as claimed in Claim 1, 2, 3, 4, 5 or 6, which is further **characterized in that** the cured material exhibits a good adherence to an adherend on which the material has been coated.

8. A thermosetting organic-inorganic hybrid transparent material as claimed in Claim 1, 2, 3, 4, 5, 6 or 7, which is further **characterized in that** the material contains a saturated hydrocarbon group, as the organic substituent.

9. A thermosetting organic-inorganic hybrid transparent material as claimed in Claim 1, 2, 3, 4, 5, 6, 7 or 8, which is further **characterized in that** the material contains an aromatic hydrocarbon group or a hydrocarbon group with aromaticity, as the organic substituent.

10. A thermosetting organic-inorganic hybrid transparent material as claimed in Claim 1, 2, 3, 4, 5, 6, 7, 8 or 9, which is further **characterized in that** the main material contains therein a thermoplastic siloxane oligomer of which average molecular weight is smaller than or equal to 2000.

11. A thermosetting organic-inorganic hybrid transparent material as claimed in Claim 1, 2, 3, 4, 5, 6, 7, 8, 9 or 10, which is further **characterized in that** the cured material has an average transmittance higher than or equal to 80% with respect to a light with wavelengths of 350 to 800nm.

12. A thermosetting organic-inorganic hybrid transparent material as claimed in Claim 1, 2, 3, 4, 5, 6, 7, 8, 9, 10 or 11, which is further **characterized in that** the adherend is previously treated by a primer.
